# EUROPEAN PATENT APPLICATION

(11) **EP 2 400 308 A1**
(43) Date of publication of application: **28.12.2011**
(21) Application number: 10460023.4
(22) Date of filing: 10.06.2010
(51) Int. Cl.: G01R 15/00, G01R 15/14, G08C 17/00, G08C 23/00

(54) **Wireless current measuring device**

(71) Applicant: ABB Technology AG, 8050 Zürich (CH)
(72) Inventor: Orman, Maciej, 32-052 Radziszów (PL); Wojcik, Mariusz, 32-552 Plaza (PL)
(74) Representative: Chochorowska-Winiarska, Krystyna

(57) **Abstract**

The invention relates to a wireless device for measuring alternating and/or direct current, broadly applicable in industrial processes and in electric power distribution networks. The wireless device for measuring alternating and/or direct current flowing in a measuring wire is characterized in that it contains a flexible conducting element (2) to whose surface at least one wireless passive stress sensor (1) is attached. The element (2) is placed in a homogenous magnetic field, on a plane parallel to the lines of the magnetic field generated by the magnetic poles (3) of a permanent magnet. The flexible element (2) is located in the space between the magnetic poles (3) so that an isolating clearance is maintained on both sides of the element (2).

## Description

The invention relates to a wireless device for measuring alternating and/or direct current, broadly applicable in industrial processes and in electric power distribution networks.

Commonly known wireless current measuring devices use known technologies based on the measurement of voltage which is generated as a result of flow of the measured current through a resistor of a specific resistance and which is then converted to current intensity. The voltage at the resistance is measured by an analog-to-digital converter which is connected to a microprocessor circuit which converts the measured voltage and indicates the measured current values or transmits information about current intensity to measuring systems. In wireless devices, microprocessor circuits collect measurement data from analog-to-digital converters and then, via radio communication, send them to measuring systems for conversion. However, microprocessor circuits require a power supply source which in the simplest case can be a supply battery or batteries which require replacement when they run out.

Patent description EP1 684 080 describes a current measuring device which uses energy gained from the electric field generated around the wire in which current is measured for supplying the microprocessor circuit, instead of batteries. This device contains a power supply system which is comprised of elements that convert energy from the electromagnetic field around the wire into supply voltage. Then the supply voltage is directed to a voltage regulator. The central element of the device is a microprocessor circuit supplied from a supply system. A system of converters which measure the current flowing through the wire is connected to the microprocessor circuit. The radio transmitter connected with the microprocessor circuit sends radio signals received from the microprocessor. The device includes also a radio receiver located outside the device, which receives signals from the device. A disadvantage of the presented device is that its operation depends on external conditions. Moreover, due to the fact that the energy of the electric field is used as the source of power supply, when small currents in the order of 1 A are measured, energy obtained from the electromagnetic field is not sufficient to power the microprocessor circuit. For that reason the device described in patent EP1 684 080 is used for measuring the currents in distribution bars, where currents in the conductors are in the order of a few kA. However, these devices cannot be used for measuring small currents. In addition, measurements of periodically operating facilities, i.e. ones that operate for a short time only, are restricted. A long stoppage in the operation of the device, when there is no current flow in the wire, results in the discharge of the energy stores in the device. In consequence, the device is not able to measure current when current flow is restarted in the wire. The device will start measuring current intensity only after a time necessary to start the supply system and to restart the microprocessor circuit and the radio transmitter.

Another patent description, US 5656931, reveals a wireless device for detecting short circuits which does not require a battery power supply for current measurement. The described device is a power supply system comprising elements that convert energy from the electromagnetic field generated around a current-carrying wire into supply voltage. Additionally, the device includes a system of solar panels which are used to power the device. Supply voltage from the solar panels is delivered to a supply switch that manages power supply sources. Supply energy is collected in capacitors connected to the supply switch. The central element of the device is a microprocessor circuit which is supplied from a supply system. The microprocessor circuit is connected with a system of converters that measure current flowing in the wire and with a radio transmitter. The radio receiver that receives signals from the device is located outside the device. Unfortunately, the supply system can be used only for measurements in places where it is possible to use and supply solar radiation.

The essence of the wireless device for measuring alternating and/or direct current flowing in a measuring wire is that it contains a flexible conducting element to whose surface at least one wireless passive stress sensor is attached. The flexible conducting element is placed in a homogenous magnetic field, on a plane parallel to the lines of the magnetic field generated by the magnetic poles of a permanent magnet. The flexible element is located in the space between the magnetic poles in such way that an isolating clearance is preserved on both sides of the flexible element.

Preferably the flexible element is integrated between two ends of the measuring wire.

Alternatively, the flexible element is connected into the connecting conductors forming an induction coil which is wound onto a magnetic core in whose window the measuring wire is located.

Preferably, the magnetic core is a fragment of a magnet keeper connecting the magnetic poles of the permanent magnet.

Preferably, the wireless passive stress sensor is made using the surface acoustic wave (SAW) generation technology.

Preferably, the wireless passive stress sensor is coupled with a transmitting antenna through a cable used for transmitting radio waves.

Preferably, the magnetic poles of the magnet that generate the homogenous magnetic field are made of neodymium.

Preferably, the flexible element is made of copper or aluminum.

Preferably, the flexible conducting element has the form of a flexible plate.

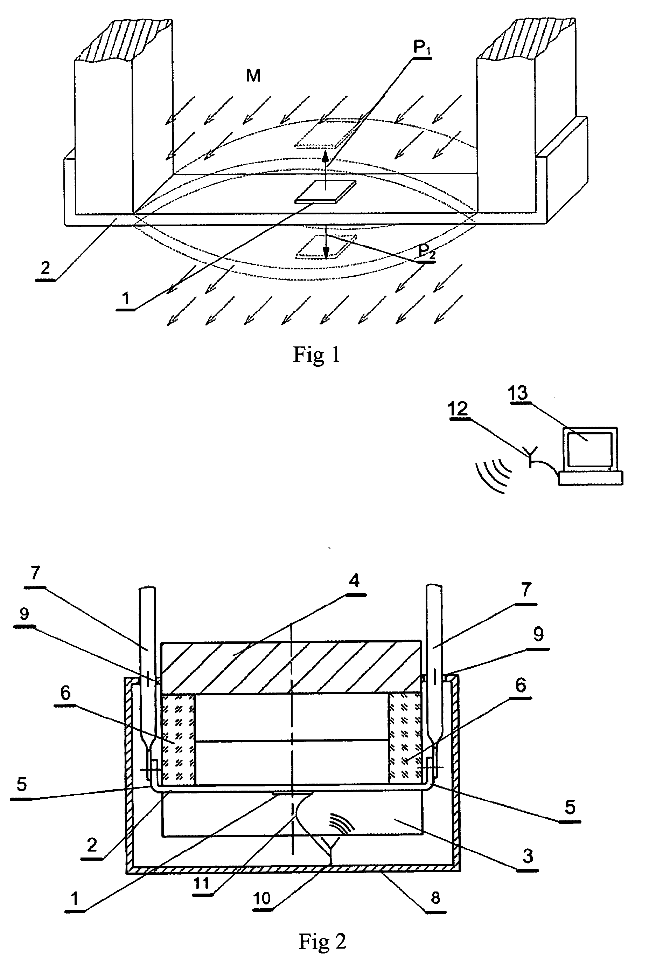

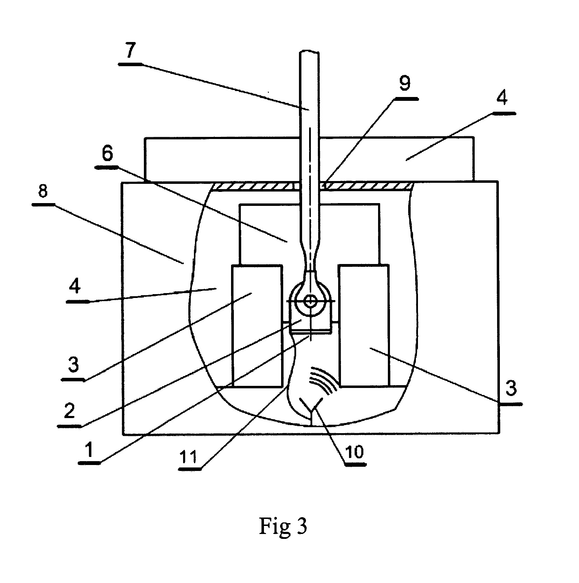

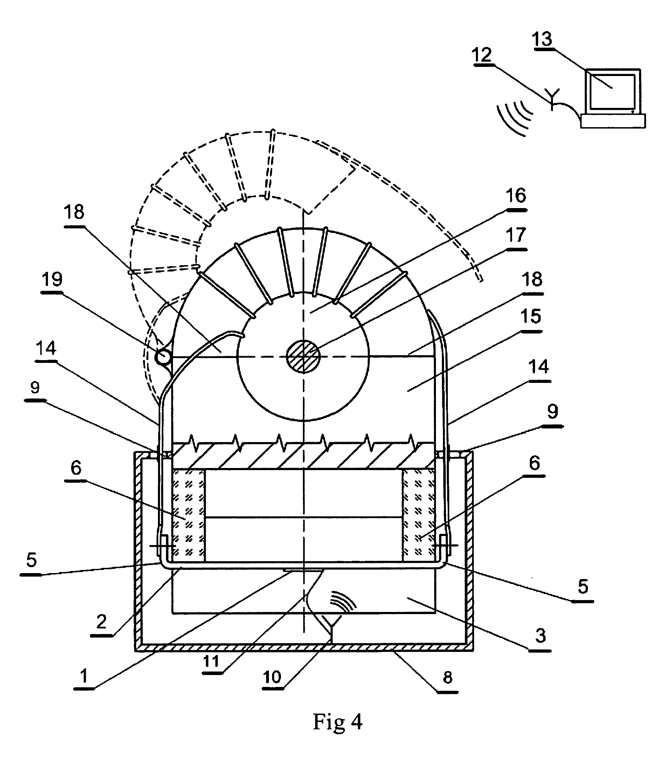

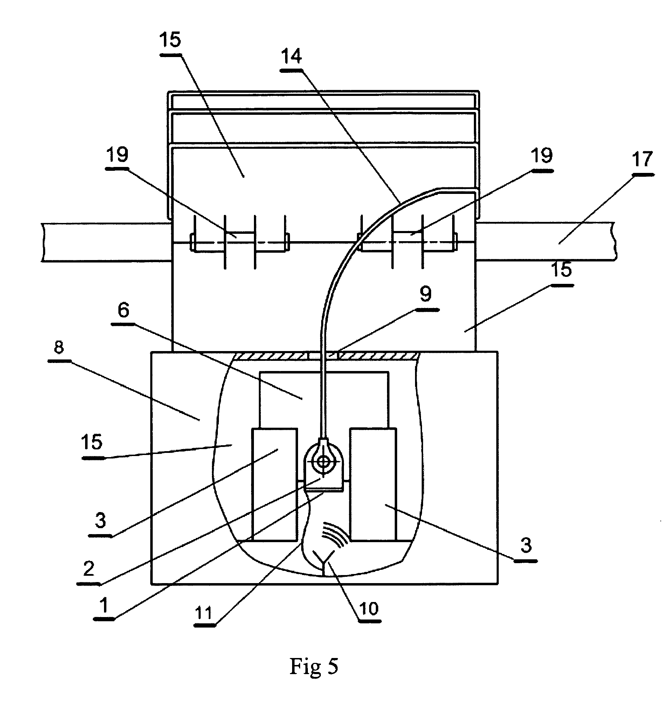

The invention is presented in an embodiment in the drawing where fig. 1 shows the schematic principle of operation of the device, fig. 2 ― the measuring device in the first embodiment of the invention, seen in a section from the side, with the data collection system, fig. 3 - the measuring device from fig. 2 seen from one of the head sides, with a fragment of a removed enclosure wall, fig. 4 ― the measuring device in the second embodiment of the invention, seen in a section from the side, with the data collection system, a fig.5 - the measuring device z fig.4, seen from one of the head sides, with a fragment of a removed enclosure wall.

The inventive device is based on the technology of wireless passive stress measurement, preferably using the Surface Acoustic Wave technology which uses radio waves for communication between the receiver and the SAW sensor. The device comprises at least one wireless passive stress sensor 1 which is attached to a flexible conducting element 2 which is made of an electrically conductive material and which is located in a homogenous magnetic field M on a plane parallel to the magnetic field lines and which preferably has the form of a flexible conductive plate. In fig. 1 the lines of the magnetic field M have been marked by arrows. The conducting flexible element 2 through which electric current flows and which is located in the magnetic field is affected by the action of the Lorentz force P acting parallel to the magnetic field lines. This force causes a deflection of the element 2 together with a stress sensor 1 in a direction perpendicular to the magnetic field lines P1 or P2. The direction of the deflection of the element 2 depends on the direction of the lines of the magnetic field generated by a permanent magnet not shown in fig. 1 and on the direction of flow of current through the element 2. The permanent magnet that generates the magnetic field has two magnetic poles 3 situated opposite each other which are connected with each other by a ferromagnetic keeper 4. The poles of the permanent magnet are polarized in such way that the magnetic field flux leaving one pole of the magnet enters the other pole and the lines of the magnetic field close inside the magnet keeper 4. The magnetic poles are permanently connected with the magnet keeper by means of known means of connecting metal surfaces.
The magnetic poles are preferably made of a neodymium material which has high remanence induction and allows to achieve high values of magnetic induction for the magnetic field M generated by the poles. The flexible element 2 in the form of a plate is inflexibly attached to insulating spacing elements 6, by its angular bends 5 situated at both ends of the plate, and it is electrically connected with two terminals 7 of the measured current-carrying wire, the terminals 7 being formed by a slit of the wire and used to connect the inventive device to the current-carrying wire. The spacing elements 6 are made of an electrically and magnetically insulating material, for example of glass or Plexiglas. The spacing elements 6 ensure the spacing of the poles 3 of the permanent magnet and they are the base for the inflexible fixing of the element 2 by means of any non-permanent fastening. The flexible element 2 is situated in the space between the magnetic poles 3, preferably at an equal distance from each of the poles 3, so that an isolating clearance is preserved on both sides of the element 2. The flexible element 2 is made of a material of good electrical conductivity and a low longitudinal modulus of elasticity in the order of 100―115 Pa, preferably of copper or aluminum. The poles 3 of the permanent magnet, the keeper 4, the spacing elements 6 and the flexible element 2 with the sensor 1 are located in an insulating housing 8 containing openings 9 for letting the terminals 7 of the current-carrying wires through them. Inside the housing 8 there is located a transmitting antenna 10 dedicated to transmitting radio waves from the sensor 1 with which it is coupled through a wire 11 that transmits radio waves. Surface acoustic waves generated by the radio wave signals in the sensor 1 are deformed when the flexible element 2 with the sensor 1 is bent and they are transmitted through the transmitting antenna 10 to a transmitting and receiving antenna 12. The transmitting and receiving antenna 12 is connected with a processing module 13 which enables the conversion of the radio signal into the measured current by a calculation program implemented in the processing module of any computer device.

In the embodiment of the invention shown in fig. 4 and 5, connecting wires 14 are connected through bends 5 to the element 2 and they form an induction coil wound onto a core 15 which is the keeper for the magnetic poles 3 and which has the shape of a semicircular ring surrounding an opening 16 in whose window the measured wire 17 is situated perpendicularly to the window surface. The core 15 has crosswise slit 18 cut along the diameter of the opening 16 and is provided with external articulated handles 19 which allow a rotational deflection of the half-ring of the core 15 and the placement of the measured wire 17 in the opening 16 without the necessity to cut the measured wire.

The operation of the device is as follows.
In the first embodiment of the invention, electric current flowing in the measured wire between its terminals 7 flows through the flexible element 2 which causes a deformation of this element under the influence of the Lorentz force. The wireless passive stress sensor 1, located on the element 2, sticking flat to its surface, is coupled with the transmitting antenna 10 which communicates with the processing module 13 by means of radio waves through the transmitting and receiving antenna 12. Stress signals measured by the sensor 1 are transmitted to the processing module and then, using known methods and known physical properties of the material of which the flexible element 2 is made, they are converted into the values of the current flowing through the element 2, which are equal to the values of the current flowing in the measured wire.
In the second embodiment of the invention, electric current flowing through the measured wire 17 causes the induction of current in the electric circuit formed by the connecting wires 14, the induction coil 16 and the flexible element 2, which in turn causes a deformation of the element 2 which together with the sensor 1 deflects from the lines of the magnetic field under the influence of the Lorentz force. The measured stress signals are transmitted and read identically to the first embodiment of the invention.

### Key to the drawing:

- 1.: Wireless passive stress sensor
- 2.: Conducting flexible element
- 3.: Magnetic poles
- 4.: Ferromagnetic keeper
- 5.: Angular bends
- 6.: Spacing element
- 7.: Terminals of current-carrying wires
- 8.: Insulating casing
- 9.: Openings for letting the current terminals through
- 10.: Transmitting antenna
- 11.: Wire transmitting radio waves
- 12.: Transmitting and receiving antenna
- 13.: Processing module
- 14.: Connecting wires
- 15.: Ferromagnetic core
- 16.: Opening intended for the measured wire
- 17.: Measured wire
- 18.: Crosswise slits
- 19.: External articulated handles

## Claims

1. A wireless device for measuring alternating and/or direct current flowing in a measuring wire (7, 17), using the transmission of radio waves for transmitting the measured data, **characterized in that** it contains a flexible conducting element (2) to whose surface at least one wireless passive stress sensor (1) is attached, and this flexible conducting element (2) is placed in a homogenous magnetic field, on a plane parallel to the lines of the magnetic field generated by the magnetic poles (3) of the permanent magnet, in the space between the magnetic poles (3), so that an isolating clearance is maintained on both sides of the flexible conducting element (2).

2. A device according to claim 1 **characterized in that** the flexible element (2) is integrated between the two ends of the measuring wire (7).

3. A device according to claim 1 **characterized in that** flexible element (2) is integrated into connecting wires (14) forming an induction coil (15) which is wound onto a magnetic core (16) in whose window the measuring wire (17) is placed.

4. A device according to claim 3 **characterized in that** the magnetic core (15) is a fragment of a magnet keeper (4) connecting the poles (3) of the permanent magnet.

5. A device according to any of the preceding claims, **characterized in that** the wireless passive stress sensor (1) is made using the surface acoustic wave (SAW) generation technology.

6. A device according to any of the preceding claims, **characterized in that** the wireless passive stress sensor (1) is coupled with a transmitting antenna (10) through a wire (11) used for transmitting radio waves.

7. A device according to any of the preceding claims, **characterized in that** the poles (3) of the magnet that generates the homogenous magnetic field are made of neodymium.

8. A device according to any of the preceding claims, **characterized in that** the flexible element (2) is made of copper or aluminum.

9. A device according to any of the preceding claims, **characterized in that** the flexible conducting element (2) has the form of a flexible plate.
